# EUROPEAN PATENT APPLICATION

(11) **EP 1 976 028 A1**
(43) Date of publication of application: **01.10.2008**
(21) Application number: 06834782.2
(22) Date of filing: 15.12.2006
(51) Int. Cl.: H01L 33/00, B29C 43/18, H01L 21/56, B29L 11/00

(54) **METHOD OF PHOTOELEMENT RESIN SEALING/MOLDING**

(30) Priority: 16.01.2006 JP 2006006922
(71) Applicant: Towa Corporation, Kyoto 6018105 (JP)
(72) Inventor: KAWAKUBO, Kazuki, Kyoto-shi Kyoto 601-8105 (JP)
(74) Representative: Willett, Christopher David
(86) International application number: PCT/JP2006/325039
(87) International publication number: WO 2007/080742

(57) **Abstract**

A top mold (4) capable of holding a substrate (1) and a bottom mold (5) including a cavity (6) having a molding portion (7) corresponding to a geometry of a lens are prepared. Then the substrate (1) with a plurality of chips (2) mounted thereon is fixed to the top mold (4). Then a translucent resin material is introduced into the cavity (6) and alters to be molten resin (9). Then the top mold (4) and the bottom mold (5) are closed together to immerse the plurality of chips (2) in the molten resin (9) and also distribute the molten resin (9) in the cavity (6) uniformly. Then the molten resin (9) alters to be a translucent mold product to provide a lens member. Subsequently the top mold (4) and the bottom mold (5) are opened to detach from the bottom mold (5) the substrate (1) bearing the lens member. Then the substrate (1) bearing the lens member is removed from the top mold (4).

## Description

### TECHNICAL FIELD

The present invention relates to methods of sealing and molding optical devices mounted on a substrate with resin.

### BACKGROUND ART

Hereinafter a conventional, general method of sealing and molding with resin will be described.

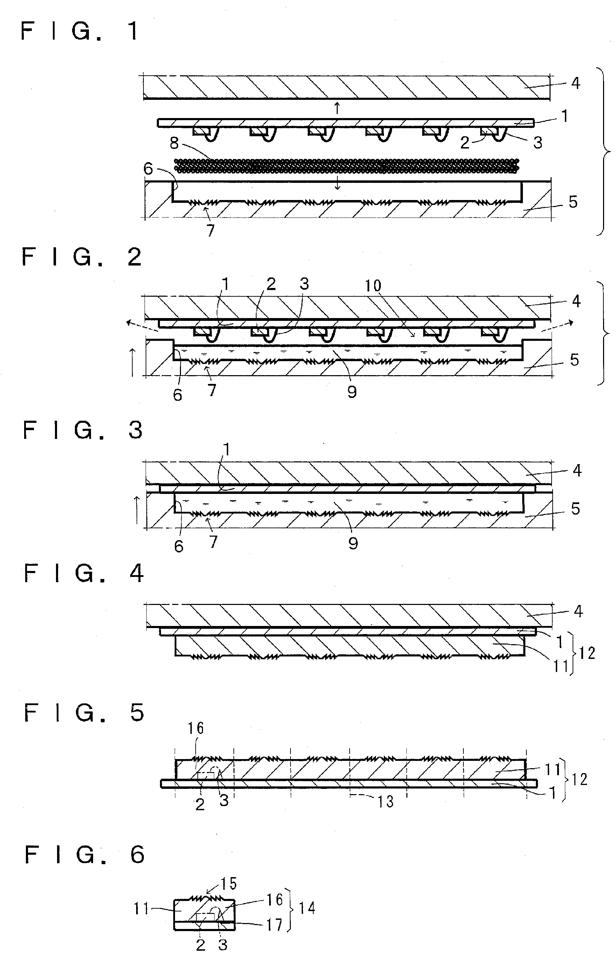

A conventional method of sealing and molding an optical device with resin is performed as follows: Initially a plurality of optical devices (light emitting diode (LED) chips) are die-bonded on a single substrate. At the time, the substrate and the LED chips have their respective electrodes wire-bonded. Subsequently for example transfer molding is employed to seal the LED chips on the substrate and the wire with a translucent resin material of epoxy resin. Subsequently the substrate is cut along a dicing line. A chip LED (a semifinished product) is thus completed (see for example Japanese Patent Laying-open No.8-78732, page 3 and Fig. 5.).

Furthermore, as done to provide a resin sealed portion of the chip LED (a semifinished product) indicated in Japanese Patent Laying-open No. 8-78732, a light emitting diode pellet (an LED chip) is sealed and molded on a substrate (or a lead frame) for example by transfer molding. A semifinished product is thus completed which is a base (or resin sealed portion) of a photoelectronic conversion device that has a square, flat geometry.

Furthermore on that base a portion in the form of a square flat plate as seen in a plane and a convex lens portion are molded for example by injection molding. A translucent resin plate (a lens plate) is thus formed. Finally, the base of the photoelectronic conversion device (or the semifinished product) and the transparent resin plate (or the lens plate) are attached. A photoelectronic component that is a transparent resin plate equipped with a lens, i.e., a finished product, is thus completed. (See for example Japanese Patent Laying-open No. 4-348088, pp. 2-3 and Figs. 1-3.) In other words, conventionally, while a chip LED or a base of a photoelectronic conversion device, or a semifinished product, is sealed with resin by transfer molding, a lens plate that is a translucent resin plate having a convex lens portion is molded by injection molding.
Patent Document 1: Japanese Patent Laying-open No. 8-78732 (page 3, Fig. 5)
Patent Document 2: Japanese Patent Laying-open No. 4-348088 (pages 2 and 3, Figs. 1-3)

### DISCLOSURE OF THE INVENTION

### PROBLEMS TO BE SOLVED BY THE INVENTION

In recent years, there is an increased demand for substrates increased in size for cost reduction, regardless of what type the substrate is of, and whether bonding is employed and what system is adopted for the bonding. Furthermore there is a tendency toward substrates reduced in thickness. Furthermore, to obtain as many optical devices as possible from a single substrate, there is an increasing tendency toward reducing optical devices per se in thickness and placing optical devices at narrower intervals. Accordingly there is an increasing tendency toward mounting a large number of optical devices on a substrate of a surface mount type in the form of a variety of large and thin maps, i.e., matrix, in addition to a conventional substrate in the form of a strip. Accordingly there is a strong demand for efficiently sealing and molding a large number of optical devices on a substrate of the surface mount type with translucent resin.

However, the conventional method of sealing and molding an optical device with resin has the following disadvantage:
If transfer molding and injection molding are both employed, both a mold assembly for the former and that for the latter are required. Furthermore the method requires some attachment mechanism apart from the mold assemblies to attach a photoelectronic component, or a semifinished product, and a lens plate to each other to complete the photoelectronic component. This requires ensuring a large space for installing the mold assemblies and the attachment mechanism in a fabrication site. Furthermore their operations, maintenances and the like entail increased workload. In other words, it is not preferable to employ both transfer molding and injection molding.

Furthermore, conventionally, the mold assemblies for transfer molding and injection molding, respectively, need to have their respective cavities with their respective internal spaces both having transparent resin introduced therein. Accordingly the mold assemblies for transfer molding and injection molding each have a resin path (a cull, a runner, a gate, a sprue or the like). There is a case, however, in which the transparent resin cannot be distributed through the resin paths to throughout the spaces in the cavities of the mold assemblies for transfer molding and injection molding, respectively, uniformly. In that case, voids or bubbles would be caused in the lens. This results in an optical device emitting light uneven in brightness, and hence a lens impaired in quality.

The present invention has been made to overcome such disadvantage and it contemplates a method of sealing and molding an optical device with resin, that does not employ both transfer molding and injection molding and can prevent a lens portion from having impaired quality.

### MEANS FOR SOLVING THE PROBLEMS

The present invention in one aspect provides a method of sealing and molding an optical device with resin, as follows: Initially, one mold capable of holding a substrate and another mold including a cavity having a lens molding portion corresponding to a geometry of a lens are prepared. Then the substrate with an optical device mounted thereon is fixed to one mold. Then translucent molten resin is present in the cavity of the other mold. Then one mold and the other mold are closed together to immerse the optical device in the molten resin and also distribute the molten resin in the cavity uniformly. Then the molten resin alters to be a translucent resin mold product to provide a lens member. Then one mold and the other mold are opened to detach from the other mold the substrate bearing the lens member. Furthermore, the substrate bearing the lens member is removed from one mold.

The present invention in another aspect provides a method of sealing and molding with resin, as follows: A first one mold capable of holding a substrate and a first other mold including a first cavity are prepared. Then the substrate with an optical device mounted thereon is fixed to the first one mold. Then translucent molten resin exists in the first cavity of the first other mold. Then the first one mold and the first other mold are closed together to immerse the optical device in the molten resin and also distribute the molten resin in the first cavity uniformly. Then the molten resin alters to be a translucent resin mold product. Then the first one mold and the first other mold are opened to detach from the first other mold the substrate bearing the translucent resin mold product. Subsequently the substrate bearing the translucent resin mold product is removed from the first one mold.

Furthermore are prepared a second one mold capable of holding the substrate bearing the translucent resin mold product and a second other mold including a second cavity having a lens molding portion corresponding to a geometry of a lens. Then the substrate bearing the translucent resin mold product is fixed to the second one mold. Subsequently another translucent resin material is introduced into the second cavity of the second other mold. Then the second one mold and the second other mold are closed together to distribute the other translucent resin material in the second cavity uniformly. Subsequently the other translucent resin material alters to be a lens mold product. Then the second one mold and the second other mold are opened to detach from the second other mold the substrate bearing a lens member formed of the translucent resin mold product and the lens mold product. Subsequently the substrate bearing the lens member is removed from the second one mold.

### EFFECTS OF THE INVENTION

The present invention can prevent impaired quality of a lens member without employing a method performing both transfer molding and injection molding.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a cross section for illustrating a method of sealing and molding an optical device with resin in a first embodiment.
Fig. 2 is a cross section for illustrating the method of sealing and molding an optical device with resin in the first embodiment.
Fig. 3 is a cross section for illustrating the method of sealing and molding an optical device with resin in the first embodiment.
Fig. 4 is a cross section for illustrating the method of sealing and molding an optical device with resin in the first embodiment.
Fig. 5 is a cross section for illustrating the step of completing a photoelectronic component (a finished product) in the first embodiment.
Fig. 6 is a cross section for illustrating the step of completing a photoelectronic component (a finished product) in the first embodiment.
Fig. 7 is a cross section for illustrating a primary molding step in the method of sealing and molding an optical device with resin in a second embodiment.
Fig. 8 is a cross section for illustrating the primary molding step in the method of sealing and molding an optical device with resin in the second embodiment.
Fig. 9 is a cross section for illustrating the primary molding step in the method of sealing and molding an optical device with resin in the second embodiment.
Fig. 10 is a cross section for illustrating a primarily molded substrate in the second embodiment, attached to a top mold.
Fig. 11 is a cross section for illustrating the primarily molded substrate in the second embodiment, detached.
Fig. 12 is a cross section for illustrating a secondary molding step in the method of sealing and molding an optical device with resin in the second embodiment.
Fig. 13 is a cross section for illustrating the secondary molding step in the method of sealing and molding an optical device with resin in the second embodiment.
Fig. 14 is a cross section for illustrating the secondary molding step in the method of sealing and molding an optical device with resin in the second embodiment.
Fig. 15 is a cross section for illustrating the secondary molding step in the method of sealing and molding an optical device with resin in the second embodiment.
Fig. 16 is a cross section of a secondarily molded substrate in the second embodiment.
Fig. 17 is a cross section of the secondarily molded substrate in the second embodiment, that is divided.
Fig. 18 is a plan view of a lens molding portion of another example of an embodiment.
Fig. 19 is a plan view of the lens molding portion of still another example of the embodiment.

### DESCRIPTION OF THE REFERENCE SIGNS

1: substrate, 2: optical device (chip), 3: wire, 4,22: top mold, 5, 23: bottom mold, 6, 18: cavity, 7, 36, 37: lens molding portion, 8, 21: translucent resin material, 9: molten resin, 10, 27: space isolated from external atmosphere, 11, 19: translucent resin mold product, 12: intermediate product, 13, 30: dicing line, 14, 31: photoelectronic component (finished product), 15, 32: lens portion, 16, 35: lens member, 17, 34: substrate, 20: primary intermediate product, 24: cavity, 25, 38, 39: translucent portion molding portion, 26: flange molding portion, 28: lens mold product, 29: secondary intermediate product, 33: flange portion

### BEST MODES FOR CARRYING OUT THE INVENTION

Hereinafter reference will be made to the drawings to describe a method of sealing and molding with resin in an embodiment of the present invention.

The present embodiment provides a method of sealing and molding an optical device with resin, that allows a mold assembly for transferless molding dispensing with a resin path, i.e., a mold assembly for compression molding, to be used to integrate together on a substrate 1 a chip 2 serving as one example of an optical device and a translucent resin mold product 11 covering chip 2 and functioning as a lens.

### First Embodiment

Reference will be made to Figs. 1-6 to describe a method of sealing and molding with resin in a first embodiment of the present invention.

In the present embodiment an optical device is implemented by way of example as a light emitting diode (LED) chip and a photoelectronic component is implemented by way of example as an LED package.

Note that the present method of sealing and molding an optical device with resin is not only applicable to an LED chip but also to a chip for a photoreceptive device converting received light to an electrical signal, such as a photodiode (PD) and a solid state image sensing device. Furthermore the present method of sealing and molding with resin is also applicable to a chip for a light emitting device emitting light in response to an electrical signal received, such as a laser diode (LD). In addition, the present method of sealing and molding with resin is applicable to sealing and molding with resin for a module used in optical communication. That is, the present method of sealing and molding with resin is applicable to sealing and molding any optical devices with resin.

The first embodiment provides the method of sealing and molding an optical device with resin, as follows: Initially, as shown in Fig. 1, a plurality of optical devices or chips 2 are mounted on a substrate 1. Then a wire 3 is used to wire-bond an electrode of chip 2 and that of substrate 1 together. Subsequently a mold assembly having a two-mold structure including opposite top and bottom molds 4 and 5 for sealing and molding with resin is prepared. Note that bottom and top molds 5 and 4 are one example of one and an other molds, respectively, of the present invention.

The aforementioned mold assembly is a mold assembly for transferless molding, i.e., compression molding. Furthermore, bottom mold 5 has a cavity 6 with a plurality of lens molding portions 7 corresponding to the plurality of chips 2 and each having a geometry of a Fresnel lens.

After chips 2 are mounted on substrate 1, substrate 1 is fixed on top mold 4, as shown in Fig. 1, by substrate attachment means such that substrate 1 is attracted, sandwiched or the like. Then, as shown in Fig. 1, a translucent resin material 8 is introduced into cavity 6. Translucent resin material 8 is a thermosetting resin formed of a resin material in the form of particles.

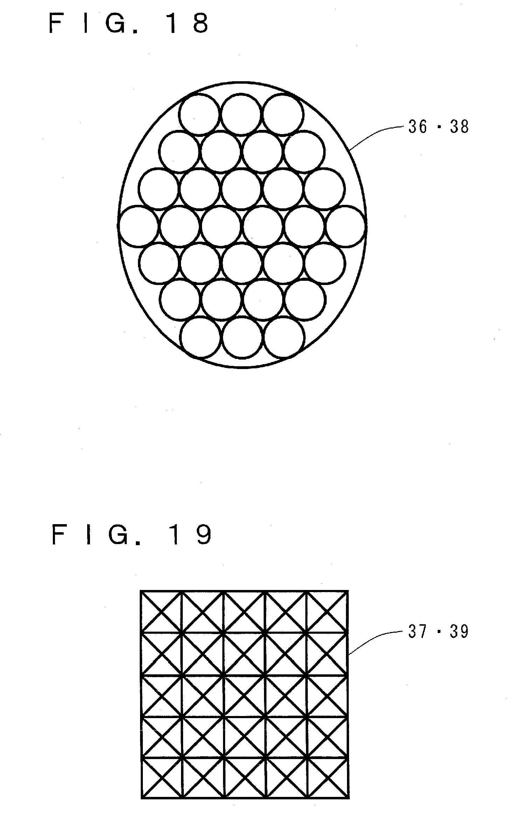

The lens molding portion would be provided in another and still another examples as a lens molding portion 36 providing small micro lenses adjacently as shown in Fig. 18 and a lens molding portion 37 providing triangular pyramids having their respective projections adjacently as shown in Fig. 19, respectively.

Furthermore, while substrate 1 having chips 2 mounted thereon is herein a wire bonded substrate, it can be a flip chip substrate, a wafer substrate used for a wafer level package, or the like. Furthermore, substrate 1 can have a round, polygonal or any similar geometry. Furthermore, substrate 1 can be formed of any metallic lead frame and be a printed circuit board or the like referred to as a PC board and formed of any plastic, ceramic, glass or other material.

Furthermore, translucent resin material 8 is required to have both a function sealing and protecting chip 2 and a function serving as a lens. Accordingly, for example, translucent epoxy resin or silicone resin can be used as translucent resin material 8. Furthermore, granular resin, liquid resin or resin in the form of a sheet can be used.

Furthermore, the mold assembly is not limited to that having the two-mold structure including top and bottom molds 4 and 5. For example, it may be a mold assembly having a three-mold structure including top mold 4 and bottom mold 5 with an intermediate mold (not shown) posed therebetween or may be a mold assembly having more than three molds.

Then, as shown in Fig. 2, translucent resin material 8 is heated and thus molten to provide molten resin 9 on cavity 6 including lens molding portion 7. Subsequently, as shown in Fig. 3, top and bottom molds 4 and 5 are closed together.

Furthermore, although not shown, top and bottom molds 4 and 5 each have its four side surfaces surrounded by a cylindrical, prismatic or similarly surrounding, external-air shutoff member, i.e., a seal mechanism.

Furthermore, when top and bottom molds 4 and 5 are closed together, the top mold's external-air shutoff member and the bottom mold's external-air shutoff member are joined together at a parting line (P.L.) plane. Furthermore, between the P.L. planes of the external-air shutoff member of the top mold, i.e., contact surfaces, is provided a tubular, hollow seal member formed for example of elastic, heat resistant rubber.

Furthermore, as shown in Fig. 2, when top and bottom molds 4 and 5 are closed together, the hollow seal member expands. This causes the hollow seal member to protrude from the P.L. plane of the external-air shutoff member of the top mold. Furthermore, the expanded hollow seal member abuts against the P.L. plane of the external-air shutoff member of the bottom mold. This forms a sealed space between top and bottom molds 4 and 5. Subsequently, air and the like are forced out of the sealed space.

Note that the hollow seal member may be replaced with an O ring or a similar seal member. Furthermore, the hollow seal member or a typical seal member may be provided at a molding surface of top and bottom molds 4 and 5, rather than an external side of top and bottom molds 4 and 5.

Thus a space 10 isolated from external atmosphere is formed in the mold assembly. Furthermore translucent resin material 8 that has molten to be molten resin 9 has therein voids formed by air bubbles, which are forced out of space 10 by suction. This can reduce voids that would otherwise remain in the lens or on a surface of the optical device.

Furthermore in the present embodiment translucent resin material 8 is heated and to do so bottom mold 5 is provided with a cartridge heater, a flexible heater or a similar heating means (not shown). Note that in place of or in addition to the heater, a contact heating plate, a non-contact halogen lamp or the like may be inserted between top and bottom molds 4 and 5.

Then, as shown in Fig. 3, top and bottom molds 4 and 5 are completely closed together. A portion corresponding to the optical device formed of the plurality of chips 2 and wire 3 is thus immersed in molten resin 9. In other words, compression molding is performed with the portion of the optical device contained in molten resin 9. Note that although in the present embodiment cavity 6 and bottom mold 5 are integrally formed, compression molding can efficiently be performed if lens molding portion 7 is divided into a plurality of portions and the plurality of portions are mutually slidable.

Furthermore while in the present embodiment substrate 1 is sandwiched between top and bottom molds 4 and 5, one of top and bottom molds 4 and 5 may have a molding surface provided with a recess (not shown) for setting substrate 1.

Then, as shown in Fig. 4, molten resin 9 is set to provide a translucent resin mold product 11. As a result, an intermediate product 12 having substrate 1 and translucent resin mold product 11 is provided. Subsequently bottom mold 5 (not shown) is moved downward to open top and bottom molds 4 and 5. Translucent resin mold product 11 serves as a collective sealing member collectively sealing the plurality of chips 2 on substrate 1. The aforementioned process thus allows compression molding to be performed to provide intermediate product 12.

Then, as shown in Fig. 5, intermediate product 12 is cut with a blade, jetted water, a laser, or the like along a virtual dicing line 13. Intermediate product 12 is thus divided for each predetermined region including chip 2.

Thus, as shown in Fig. 6, a plurality of completed products are provided. The completed product is a photoelectronic component 14, i.e., an LED package. Photoelectronic component 14 includes substrate 1 having been divided, or a substrate 17, chip 2 attached on an upper surface of substrate 17, and a lens member 16 having a lens portion 15 in the form of a Fresnel lens and also sealing chip 2.

In the present embodiment the method of sealing and molding an optical device with resin allows molten resin 9 to be distributed in cavity 6 uniformly along the geometry of lens molding portion 7. Thus there is no void remaining in lens member 16 and the lens member can thus be prevented from having poor quality.

Furthermore in the present embodiment the method of sealing and molding an optical device with resin can provide the following effects:
First, a resin sealing and molding apparatus that performs compression molding with a mold assembly used for transferless molding can be used alone. This can reduce a space occupied in a fabrication site to install a fabrication apparatus. Furthermore, it can also reduce an amount of workload such as operation, maintenance and the like.
Second, even if any translucent resin material 8 is used and cavity 6 has lens molding portion 7 or a similarly peculiar geometry, transferless molding dispensing with a resin path, i.e., compression molding, allows molten resin 9 to be distributed throughout a space in the cavity uniformly.
Third, space 10 isolated from external atmosphere is formed in the mold assembly. While translucent resin material 8 that has molten, or molten resin 9, has therein voids formed by air bubbles, such space 10 allows the air bubbles to be forced out thereof by suction. This can efficiently prevent voids that would otherwise be formed in the lens or on the portion of the optical device.

### Second Embodiment

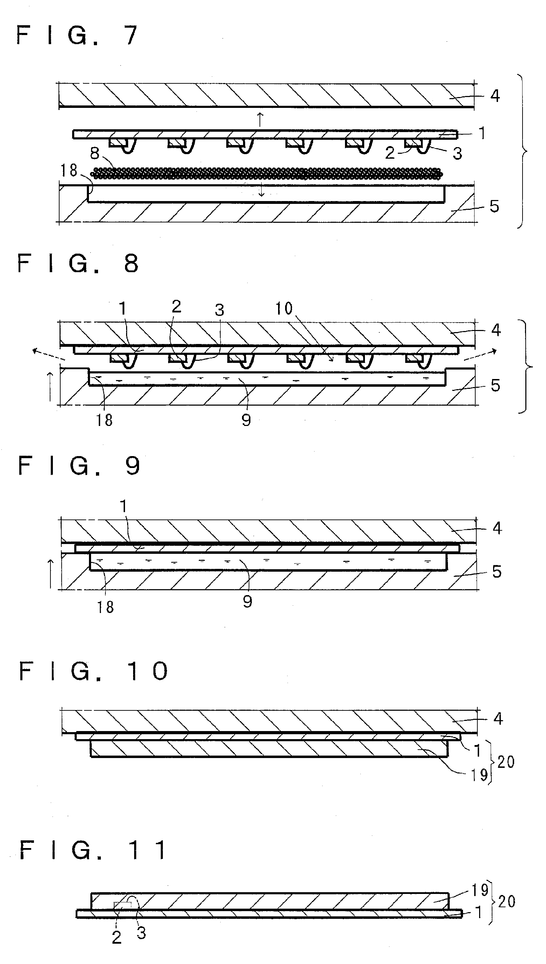

Reference will be made to Figs. 7-17 to describe the present method of sealing and molding with resin in a second embodiment.

In Figs. 7-17 the components identical to those shown in Figs. 1-6 are identically denoted. Accordingly, the components having been described in the first embodiment will not be described repeatedly unless it is necessary to do so.

Furthermore, as well as the first embodiment, the present embodiment also employs an LED chip as an optical device and an LED package as an photoelectronic component for the sake of illustration. Furthermore, similarly as has been described in the first embodiment, the present method of sealing and molding an optical device with resin is applicable to sealing with resin not only an LED chip but also a chip of a photodiode or a similar photoreceptive device, a solid state image sensing device and the like, a chip of a laser diode or a similar light emitting device, and a module used in optical communication.

Furthermore the method of sealing and molding with resin in the present embodiment is different from that in the first embodiment in that a sealing portion of an optical device that seals chip 2 and a lens portion externally transmitting light emitted from chip 2 are compression-molded individually.

In other words, the method in the present embodiment includes more steps than that in the first embodiment. However, the method in the present embodiment allows a lens portion having a peculiar geometry of a Fresnel lens to be formed quickly with high precision. In other words, the method allows the lens portion to be alone, individually formed to provide a lens member improved in quality.

To do so, the present embodiment provides the method of sealing and molding with resin, as follows: Initially a sealing portion is formed by primary molding to contain a chip therein. Then a lens portion is pressed and thus bonded to the sealing portion. A lens member in the form of a Fresnel lens is thus formed. This step is a secondary molding (or printing) step.

More specifically, the second embodiment provides the method of sealing and molding an optical device with resin, as follows: Initially, as shown in Fig. 7, a plurality of chips 2 are mounted on substrate 1. Then the plurality of chips 2 are bonded to substrate 1 with wire 3. Subsequently a mold assembly having a two-mold structure including opposite top and bottom molds 4 and 5 for sealing and molding with resin is prepared. Note that bottom and top molds 5 and 4 in the present embodiment are also one example of one and an other molds, respectively, of the present invention. Furthermore, the mold assembly is that for transferless molding, i.e., compression molding.

In the present embodiment, in contrast to the first embodiment, bottom mold 5 has a cavity 18 that does not have a geometry of a Fresnel lens, as shown in Fig. 7.

Furthermore, substrate 1 is attracted, sandwiched or the like, and thus fixed on top mold 4. Furthermore, cavity 18 receives translucent resin material 8, as shown in Fig. 7. Translucent resin material 8 is a predetermined amount of a material of resin in the form of particles formed of thermosetting resin.

In the present embodiment bottom mold 5 has cavity 18 that does not have a geometry corresponding to that of a lens. As such, translucent resin material 8 is no more in amount than that used in the first embodiment.

Note that similarly as has been described in the first embodiment, chip 2 and substrate 1 are not limited to those aforementioned, and may be another chip and another substrate.

Furthermore, translucent resin material 8 may be any of epoxy resin, silicone resin, granular resin, liquid resin and resin in the form of a sheet, that has a function serving as a sealing portion for protecting chip 2 and is also translucent.

Furthermore, similarly as has been described in the first embodiment, the mold assembly is not limited to a two-mold structure and may have a three- or more-mold structure.

Then, as shown in Fig. 8, translucent resin material 8 is heated and thus molten to provide molten resin 9 in cavity 18. Furthermore, top and bottom molds 4 and 5 are closed together.

Furthermore, similarly as has been described in the first embodiment, an external-air shutoff member (a seal mechanism) associated with the top mold and an external-air shutoff member (a seal mechanism) associated with the bottom mold, and a hollow seal member are also provided. Thus, similarly as has been described in the first embodiment, air bubbles forming voids in translucent resin material 8 that has molten or molten resin 9 can be forced out by suction. This can prevent voids from remaining in the sealing portion when translucent resin material 8 becomes the sealing portion.

Furthermore, similarly as has been described in the first embodiment, translucent resin material 8 is heated and to do so bottom mold 5 is provided with a cartridge heater, a flexible heater or a similar heating means (not shown). In place of or in addition to the heater, a contact heating plate, a non-contact halogen lamp or the like may be inserted between top and bottom molds 4 and 5.

Then, as shown in Fig. 9, top and bottom molds 4 and 5 are completely closed together. Chips 2 and wire 3 are thus immersed in molten resin 9, and thus contained in molten resin 9 and compression molding is performed. This is a primary molding step. Furthermore, similarly as has been described in the first embodiment, cavity 18 and bottom mold 5 may be formed integrally, and if bottom mold 5 is divided into a plurality of components and the plurality of components are mutually slidable, compression molding is efficiently performed.

Furthermore while a mold assembly sandwiching substrate 1 by top and bottom molds 4 and 5 is used, one of top and bottom molds 4 and 5 may have a molding surface provided with a recess (not shown) accommodating substrate 1.

Then, as shown in Fig. 10, molten resin 9 is set to provide a translucent resin mold product 19, which does not have a lens portion formed of set resin. Simultaneously, an intermediate product 20 having substrate 1 and translucent resin mold product 19 is provided. Subsequently bottom mold 5 (not shown) is moved downward to open top and bottom molds 4 and 5. Translucent resin mold product 19 serves as a sealing portion collectively sealing each chip 2 on substrate 1.

The aforementioned first molding step, i.e., compression molding, provides primary intermediate product 20 as shown in Fig. 11.

In the present embodiment primary intermediate product 20 includes substrate 1, chip 2 mounted on an upper surface of substrate 1, and translucent resin mold product 19 sealing chip 2.

In the present embodiment the method of sealing and molding with resin ensures that each chip 2, wire 3 and other elements of an optical device are protected by translucent resin mold product 19.

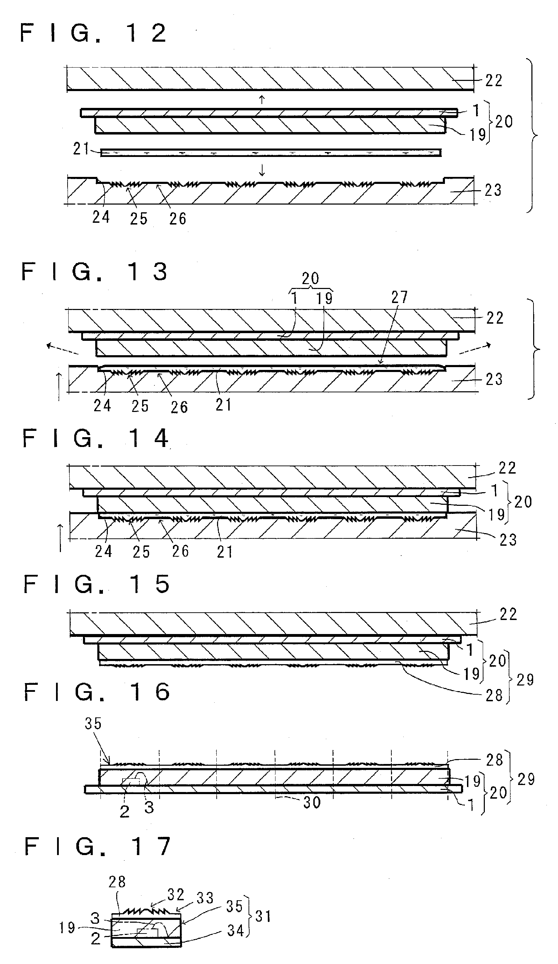

Then, as shown in Fig. 12, a mold assembly having a two-mold structure including opposite top and bottom molds 22 and 23 for sealing and molding with resin is prepared. Note that top and bottom molds 22 and 23 are one example of one and an other molds, respectively, of the present invention. This mold assembly is also that for transferless molding.

In the present embodiment bottom mold 23 has a lens molding cavity 24. Cavity 24 has a translucent portion molding portion 25 having a geometry of a Fresnel lens corresponding to each of the plurality of chips 2, and a flange molding portion 26 in the form of a flat plate.

Furthermore, substrate 1 bearing translucent resin mold product 19, or primary intermediate product 20 as shown in Fig. 11, is fixed on top mold 22, as shown in Fig. 12, by substrate attachment means such that substrate 1 is attracted, sandwiched or the like.

Furthermore, as shown in Fig. 12, cavity 24 receives another translucent resin material 21. Translucent resin material 21 is a resin material formed of a translucent thermosetting resin in the form of a sheet having a predetermined volume.

In the method of sealing and molding with resin in the present embodiment cavity 24 is provided for molding a lens having a geometry of a Fresnel lens associated with each of the plurality of chips 2 in translucent resin mold product 19 formed on substrate 1. Thus a lens portion can be pressed and thus bonded to a sealing portion by compression molding employing a mold assembly excluding a resin path and used for transferless molding. This step of integrating the sealing portion and the lens portion together is a secondary molding step.

In the present embodiment another lens molding cavity 24 may have translucent portion molding portion 25 implemented by a translucent portion molding portion 38 providing small micro lenses adjacently as shown in Fig. 18 or a translucent portion molding portion 39 providing quadrangular pyramids having their respective projections adjacently as shown in Fig. 19.

Note that Figs. 18 and 19 shows translucent portion molding portions 38 and 39 in a plan view as seen downward.

Note that translucent resin material 21 may be any of epoxy resin, silicone resin, and liquid resin that functions as a lens and is also translucent. If the liquid resin is used, translucent resin mold product 19 shown in Fig. 11 is preferably higher in elastic modulus than material 21 of resin in the form of a sheet.

Furthermore the mold assembly is not limited to that having the two-mold structure including top and bottom molds 22 and 23. For example, it may be a mold assembly having a three-mold structure including top mold 22 and bottom mold 23 with an intermediate mold (not shown) posed therebetween or may be a mold assembly having more than three molds.

Furthermore in the present embodiment the method of sealing and molding with resin requires a molding apparatus equipped with two mold assemblies, rather than a single mold assembly. In other words, it requires a larger space in a fabrication side to install the apparatus than that of the first embodiment. However, it does not require a molding apparatus equipped with a mold assembly and another molding apparatus equipped with another mold assembly, as conventional. Rather, it only employs a single molding apparatus having two mold assemblies equipped therein. It can thus reduce an amount of workload such as operation, maintenance and the like.

The molding apparatus may for example be that which has top mold 4 and top mold 22 provided by a single mold, and bottom mold 5 and another bottom mold 23 individually provided and alternately slid to move toward a predetermined position of top mold 4 (or 22). Furthermore, the molding apparatus may be a modular molding apparatus having two independent mold assemblies arranged in parallel and employing a transfer means to move substrate 1 from a space formed between top mold 4 and bottom mold 5 to that formed between top mold 22 and bottom mold 23.

Then, as shown in Fig. 13, translucent resin material 21 is heated and thus molten to provide molten translucent resin material 21 on cavity 24. Top and bottom molds 22 and 23 are closed together.

Note that although not shown, similarly as has been described in the first embodiment, an external-air shutoff member (a seal mechanism) associated with the top mold and an external-air shutoff member (a seal mechanism) associated with the bottom mold, and a hollow seal member are provided as an enclosure of top mold 22 and bottom mold 23. Furthermore, the hollow seal member may be replaced with an O ring or a similar seal member, and one of top mold 22 and bottom mold 23 may be provided on its contact surface with the hollow seal member or the similar seal member.

This allows a space 27 isolated from external atmosphere to be formed between top mold 22 and bottom mold 23. Molten translucent resin material 21 contains voids formed by air bubbles, which can be forced out through space 27 by suction. This can prevent voids formed in a lens.

Furthermore to heat translucent resin material 21 bottom mold 23 is also provided with a cartridge heater, a flexible heater or a similar heating means (not shown). Furthermore in place of or in addition to the heater, a contact heating plate, a non-contact halogen lamp or the like may be inserted between top and bottom molds 22 and 23.

Then, as shown in Fig. 14, top mold 22 and bottom mold 23 are completely closed together. Furthermore, molten translucent resin material 21 presses and bonds translucent resin material 21 that has been reformed in the form of a Fresnel lens to translucent resin mold product 19. This step is compression molding (print-molding), i.e., a secondary molding step.

While in the present embodiment cavity 24 and bottom mold 23 are integrally formed, compression molding can efficiently be performed if lens molding cavity 24 is divided into a plurality of components and the plurality of components are mutually slidable.

Furthermore while in the present embodiment substrate 1 is sandwiched and thus held by top and bottom molds 22 and 23, one of top and bottom molds 22 and 23 may have a molding surface provided with a recess (not shown) accommodating substrate 1.

Furthermore, when top and bottom molds 22 and 23 are closed together, a force more than required for pressing and thus bonding is exerted to translucent resin mold product 19 on substrate 1, when translucent resin material 21 is present in lens molding cavity 24 in a predetermined amount or more, which ensures that the resin is distributed into a narrow groove of lens molding cavity 24 corresponding to a peculiar geometry of a Fresnel lens. A high quality lens member is thus formed. This is because when the secondary molding step is performed translucent resin mold product 19 presses translucent resin material 21 against lens molding cavity 24. In other words, this is because translucent resin material 21 is compression-molded.

Then, as shown in Fig. 15, molten translucent resin material 21 is set to form a lens mold product 28. Furthermore, a secondary intermediate product 29 having substrate 1, translucent resin mold product 19 and lens mold product 28 is formed. Subsequently bottom mold 23 (not shown) moves downward and top mold 22 and bottom mold 23 are thus opened. In the present embodiment lens mold product 28 does not serve as a sealing portion collectively sealing the plurality of chips 2 on substrate 1. Rather, lens mold product 28 serves as a lens portion. Thus secondary intermediate product 29 is formed. This is a secondary molding step.

Then, as shown in Fig. 16, secondary intermediate product 29 is cut with a blade, jetted water, a laser, or the like along a virtual dicing line 30. Secondary intermediate product 29 is thus divided for each region including chip 2.

The above process completes a photoelectronic component 31 (or an LED package) of the present embodiment, as shown in Fig. 17, including substrate 1 having been divided, or a substrate 34, and a chip 2 attached on substrate 34. Chip 2 is sealed by lens member 35. Lens member 35 is formed of lens mold product 28 and translucent resin mold product 19. Lens mold product 28 is formed of lens portion 32 in the form of a Fresnel lens and a flange portion 33 in the form of a flat plate.

In the present embodiment flange portion 33 surrounds lens portion 32 in the form a plane, and if flange molding portion 26 has a structure separated from translucent portion molding portion 25, flange portion 33 can be minimized in thickness.

Furthermore, lens mold product 28 which does not have flange portion 33 and only has lens portion 32 may be provided. Lens member 35 without flange portion 33 allows photoelectronic component 31 of the present embodiment to have lens member 35 substantially equal in thickness to lens member 16 of photoelectronic component 14 of the first embodiment.

The present embodiment can also provide a method of sealing and molding with resin, that is as effective as that obtained in the first embodiment.

Although the present invention has been described and illustrated in detail, it is clearly understood that the same is by way of illustration and example only and is not to be taken by way of limitation, the scope of the present invention being interpreted by the terms of the appended claims.

## Claims

1. A method of sealing and molding an optical device with resin, comprising the steps of:
preparing one mold (4) capable of holding a substrate (1) and another mold (5) including a cavity (6) having a lens molding portion (7) corresponding to a geometry of a lens;
fixing to said one mold (4) said substrate (1) having an optical device (2) mounted thereon;
allowing molten resin (9) to be present in said cavity (6) of said other mold (5);
closing said one mold (4) and said other mold (5) together to immerse said optical device (2) in said molten resin (9) and also distribute said molten resin (9) in said cavity (6) uniformly;
altering said molten resin (9) to be a translucent resin mold product (11) to provide a lens member (16);
opening said one mold (4) and said other mold (5) to detach from said other mold (5) said substrate (1) bearing said lens member (16); and
removing from said one mold (4) said substrate (1) bearing said lens member (16).

2. A method of sealing and molding an optical device with resin, comprising the steps of:
preparing a first one mold (4) capable of holding a substrate (1) and a first other mold (5) including a first cavity (18);
fixing to said first one mold (4) said substrate (1) having an optical device (2) mounted thereon;
introducing a translucent resin material (8) into said first cavity (18) of said first other mold (4);
altering said translucent resin material (8) to be molten resin (9);
closing said first one mold (4) and said first other mold (5) together to immerse said optical device (2) in said molten resin (9) and also distribute said molten resin (9) in said first cavity (6) uniformly;
altering said molten resin (9) to be a translucent resin mold product (19);
opening said first one mold (4) and said first other mold (5) to detach from said first other mold (5) said substrate (1) bearing said translucent resin mold product (19);
removing from said first one mold (4) said substrate (1) bearing said translucent resin mold product (19);
preparing a second one mold (22) capable of holding said substrate (1) bearing said translucent resin mold product (19) and a second other mold (23) including a second cavity (24) having a lens molding portion (25) corresponding to a geometry of a lens;
fixing to said second one mold (22) said substrate (1) bearing said translucent resin mold product (19);
introducing another translucent resin material (21) into said second cavity (24) of said second other mold (23);
closing said second one mold (23) and said second other mold (24) together to distribute said other translucent resin material (21) in said second cavity (6) uniformly;
altering said other translucent resin material (21) to be a lens mold product (28);
opening said second one mold (22) and said second other mold (23) to detach from said second other mold (23) said substrate (1) bearing a lens member (35) formed of said translucent resin mold product (19) and said lens mold product (28); and
removing from said second one mold (22) said substrate (1) bearing said lens member (35).

## Amended claims

### Amended claims under Art. 19.1 PCT

**1.** (Amended) A method of sealing and molding an optical device with resin, comprising the steps of:
preparing one mold (4) capable of holding a substrate (1) and another mold (5) including a cavity (6) having a lens molding portion (7) corresponding to a geometry of a lens;
fixing to said one mold (4) said substrate (1) having an optical device (2) mounted thereon;
allowing molten resin (9) to be present in said other mold (5) directly in contact with a molding surface of said cavity (6);
closing said one mold (4) and said other mold (5) together to immerse said optical device (2) in said molten resin (9) and also distribute said molten resin (9) in said cavity (6) uniformly;
altering said molten resin (9) to be a translucent resin mold product (11) to provide a lens member (16);
opening said one mold (4) and said other mold (5) to detach from said other mold (5) said substrate (1) bearing said lens member (16); and
removing from said one mold (4) said substrate (1) bearing said lens member (16).

**2.** (Amended) A method of sealing and molding an optical device with resin, comprising the steps of:
preparing a first one mold (4) capable of holding a substrate (1) and a first other mold (5) including a first cavity (18);
fixing to said first one mold (4) said substrate (1) having an optical device (2) mounted thereon;
allowing molten resin (9) to be present in said first other mold (4) directly in contact with a moulding surface of said first cavity (18);
closing said first one mold (4) and said first other mold (5) together to immerse said optical device (2) in said molten resin (9) and also distribute said molten resin (9) in said first cavity (6) uniformly;
altering said molten resin (9) to be a translucent resin mold product (19);
opening said first one mold (4) and said first other mold (5) to detach from said first other mold (5) said substrate (1) bearing said translucent resin mold product (19);
removing from said first one mold (4) said substrate (1) bearing said translucent resin mold product (19);
preparing a second one mold (22) capable of holding said substrate (1) bearing said translucent resin mold product (19) and a second other mold (23) including a second cavity (24) having a lens molding portion (25) corresponding to a geometry of a lens;
fixing to said second one mold (22) said substrate (1) bearing said translucent resin mold product (19);
introducing another translucent resin material (21) into said second other mold (23) to be contact directly with a molding surface of said second cavity (24);
closing said second one mold (23) and said second other mold (24) together to distribute said other translucent resin material (21) in said second cavity (6) uniformly;
altering said other translucent resin material (21) to be a lens mold product (28);
opening said second one mold (22) and said second other mold (23) to detach from said second other mold (23) said substrate (1) bearing a lens member (35) formed of said translucent resin mold product (19) and said lens mold product (28); and
removing from said second one mold (22) said substrate (1) bearing said lens member (3 5).
